Europäisches Patentamt

European Patent Office

Office européen des brevets

(11) Publication number: **0 001 892**
**B1**

# EUROPEAN PATENT SPECIFICATION

(45) Date of publication of patent specification: **23.09.81**

(21) Application number: **78300494.8**

(22) Date of filing: **12.10.78**

(51) Int. Cl.³: **H 01 L 23/48,**
**H 01 L 23/04, H 01 L 21/48**

(54) Lead frame and package for establishing electrical connections to electronic components.

(30) Priority: **27.10.77 US 846052**

(43) Date of publication of application:
**16.05.79 Bulletin 79/10**

(45) Publication of the grant of the European patent:
**23.09.81 Bulletin 81/38**

(84) Designated Contracting States:
**BE DE FR GB NL SE**

(56) References cited:
**GB - A - 785 452**
**US - A - 3 258 681**
**US - A - 3 597 666**
**US - A - 3 778 887**

(73) Proprietor: **AMP INCORPORATED**
**Eisenhower Boulevard**
**Harrisburg, Pennsylvania (US)**

(72) Inventor: **Keller, Joseph Richard**
**2406 Walker Mill Road R.D. No. 2**
**Harrisburg Pennsylvania (US)**

(74) Representative: **Stuart-Prince, Richard Geoffrey**
**et al,**
**20 Queensmere**
**Slough, Berkshire SL1 1YZ (GB)**

Courier Press, Leamington Spa, England.

Lead frame and package for establishing electrical connections to electronic components

This invention relates to lead frames for establishing electrical connections to electronic components, such as transistors, triacs or integrated circuit chips.

Electrical connections are often made to electronic components using a lead frame stamped and formed from sheet metal and comprising a plurality of contact arms arranged for connection to respective contact areas of an electronic component, each arm having integrally formed therewith a terminal member for connection to an external conductor. Initially, all parts of the lead frame are integrally formed together with a carrier strip arrangement which carries a plurality of similar lead frames each of which is severed from the carrier strip arrangement, and the contact arms electrically isolated from each other, prior to use.

Often after mounting of an electronic component on the lead frame, the component and portions of the lead frame are encapsulated in an electrically insulating material such as an epoxy resin, leaving free end portions of the terminal members exposed for connection to external circuitry.

Such packages are generally mounted on printed circuit boards, the exposed portions of the terminal members being received and soldered in holes in the board, or being plugged into receptacle contacts mounted on a printed circuit board.

Thus, with known lead frames and packages incorporating such lead frames, the terminal members are of small size and have a thickness equal to the thickness of the sheet metal from which the lead frame is stamped and formed.

However, there is now a growing requirement for the inclusion of electronic components in electrical arrangements comprises of conventional insulated wiring, for example, in the control circuits of domestic electrical appliances, and known lead frames and packages are not readily suitable for such use.

According to this invention a lead frame stamped and formed from sheet metal and comprising a plurality of contact arms arranged for connection to respective contact areas of an electronic component, each arm having integrally formed therewith a terminal member for connection to an external conductor, is characterised in that each terminal member is formed of a plurality of thicknesses of the sheet metal by folding part of the sheet metal constituting the terminal members and is shaped to mate with a complementary terminal terminating an insulated conductor.

Preferably, each terminal member is in the form of a tab whereby the terminal member can be mated with a conventional tab receptacle terminating an insulated conductor.

Thus, using the lead frame of this invention an electronic component can be packaged such that the package can be directly connected into an electrical arrangement comprised of conventional insulated conductors simply by mating the terminal members of the lead frame with complementary terminals terminating the insulated conductors.

This invention will now be described by way of example with reference to the drawings, in which:-

Figure 1 is a perspective view of a lead frame according to this invention, still connected to parts of a carrier strip arrangement on which it is formed;

Figure 2 is a plan view of a stamped blank from which the lead frame of Figure 1 is formed;

Figure 3 is a view similar to Figure 1 but of a further lead frame according to this invention;

Figure 4 is a perspective view of a stamped blank from which the lead frame of Figure 3 is formed;

Figure 5 is a perspective view illustrating the manufacture of a package containing an electronic component using a lead frame as shown in Figures 3 and 4; and

Figure 6 is a section on the lines VI—VI in Figure 5.

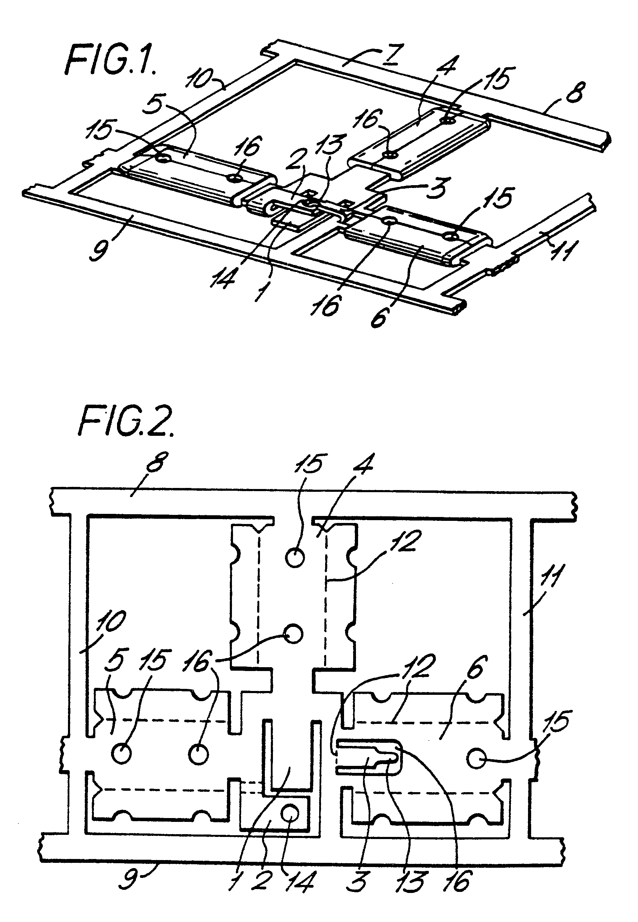

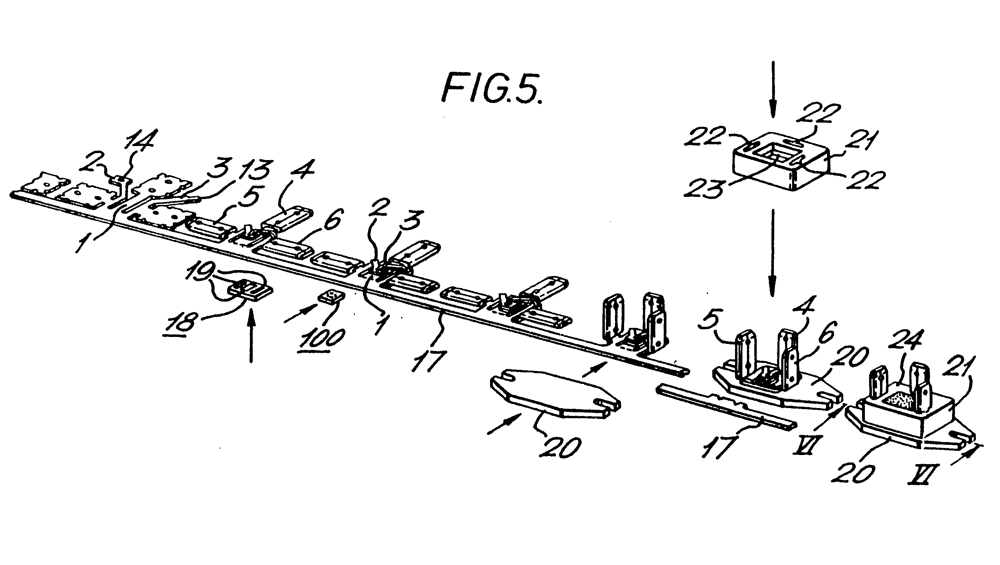

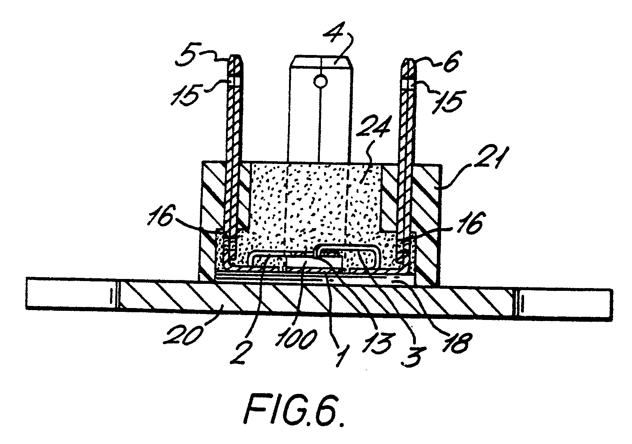

Figure 1 shows a lead frame stamped and formed from sheet metal such as OFHC copper 0.015 inches (0.36 mm) thick, the lead frame having three contact arms 1, 2 and 3 for connection to respective contact areas of an electronic component (100 in Figures 5 and 6).

Each arm 1, 2 or 3, has integrally formed therewith a terminal member 4, 5 or 6, respectively, in the form of a tab for mating with a complementary tab receptacle (not shown) each tab 4, 5 or 6 being formed of two thicknesses of the sheet metal from which the lead frame is formed.

The lead frame is shown in Figure 1 still connected to parts of a carrier strip arrangement 7 on which the lead frame is stamped and initially formed together with a plurality of similar lead frames, this in known manner. Thus, as shown in Figures 1 and 2, all the parts of the lead frame, that is the contact arms 1, 2 and 3, and the associated terminal members 4, 5 and 6, are initially integrally formed and subsequently electrically isolated as required as will be described later with reference to Figure 5. As shown, the lead frame is carried by a pair of spaced, parallel side carrier strips 8 and 9, between a pair of cross carrier strips 10 and 11 the carrier strip arrangement 7 being of ladder form. The outer ends of the terminal members 4, 5 and 6, are integral with the carrier strips 8, 10 and 11 respectively, while the inner end of terminal member 6 and the associated contact arm 3 is connected to the carrier strip 9.

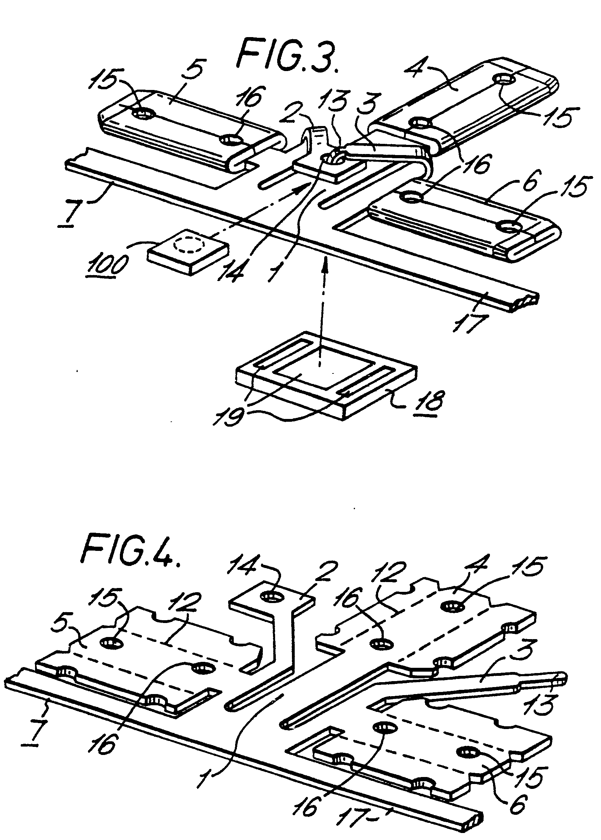

Figure 2 shows in dashed lines 12, the lines about which the blank is folded to form the structure shown in Figure 1. As shown, the contact arm 2 is folded to overlie the contact arm 1, while the contact arm 3 is folded to extend towards the contact arm 2, with a free end portion 13 of the contact arm 3 being of reduced width to extend through a hole 14 in the contact arm 2. In use, an electronic component (100 in Figures 3 and 5) is mounted on the contact arm 1 which makes electrical contact with a first contact area on one side of the electronic component, while the contact arm 2 and the free end of the contact arm 3 make electrical contact with second and third concentric contact areas on the opposite side of the electronic component, the free end 13 of the arm 3 projecting through the hole 14 in the arm 2 as shown in Figure 1.

Each of the terminal members 4, 5 and 6, is formed with two axially spaced through holes, the outer one 15 of which in use receives a projection on a complementary receptacle mated therewith, in known manner, and the inner one 16 of which serves a mechanical strain-relief function after encapsulation of the lead frame, as will be described later.

The lead frame shown in Figures 3 and 4 is basically similar to that shown in Figures 1 and 2, and corresponding parts have the same reference numerals.

The basic difference is that the carrier strip arrangement 7 comprises a single strip 17 to which the inner ends of the terminal members 5 and 6, and the outer end of the contact arm 1, are initially connected.

Figure 3 also shows an electronic component 100 for mounting on the lead frame, and a substrate 18 of electrically insulating material, preferably heat conducting insulating material such as BeO. The substrate 18 has three bands 19 of metalisation on its upper surface (as seen in Figure 3) and the bottom surface of the substrate 18 is completely metalised.

For use of the lead frame, root parts of the terminal members 4, 5 and 6, including the contact arm 1, are bonded as by soldering to the metalised bands 19 on the substrate 18, and the carrier strip 17 is then removed from the lead frame to isolate the three contacts arms 1, 2 and 3, and with them the associated contact members 4, 5 and 6, electrically from each other, the substrate 18 then serving to support the three separate contact arms 1, 2 and 3, in the correct relative positions. The electronic component 100 can then be mounted on the contact arm 1 with the contacts 2 and 3 making connections to contact areas of the component as described above.

Referring now to Figure 5, this illustrates the manufacture of a package comprising an electronic component 100 encapsulated in an insulating housing, and mounted on a heat sink, using a lead frame as shown in Figures 3 and 4.

As shown, a blank (as shown in Figure 4) for the lead frame is stamped together with a plurality of similar blanks on the carrier strip 17.

The blank is then formed into a lead frame as shown in Figure 3, and the substrate 18 and electronic component 100 are mounted on the lead frame as described above.

The terminal members 4, 5 and 6, are then bent to extend parallel to each other and normally of the plane of the carrier strip 17, and a metal heat sink member 20 is bonded by soldering to the lower metalised surface of the substrate 18. The carrier strip 17 is then severed from the lead frame to isolate the contact arms 1, 2 and 3, with their associated terminal members 4, 5 and 6 from each other, as described above.

A rectangular frame housing 21 of electrically insulating plastics material is then mounted over the terminal members 4, 5 and 6, the housing 21 having individual through holes 22 for the terminal members 4, 5 and 6, and a central through hole 23. The housing 21 is then filled with an encapsulating material 24, the holes 22 each having a narrow groove along one wall to provide an escape vent for air to ensure that the material 24 completely fills the housing 21.

Referring now to Figure 6 also, the walls of the housing 21 are cut away at their inner ends so as to expose the holes 16 in the terminal members 4, 5 and 6 to the encapsulating material 24 which thus flows into the holes 16 thereby to secure the housing 21 to the lead frame structure. The connections between the contact arms 1, 2 and 3, and the electronic component 100 are thus also protected from forces applied to the exposed ends of the terminal members 4, 5 and 6.

The package thus manufactured can easily be connected into a circuit as required by mating the exposed terminal tabs 4, 5 and 6, with appropriate receptacles, for example three receptacles mounted in a common housing.

**Claims**

1. A lead frame stamped and formed from sheet metal and comprising a plurality of contact arms arranged for connection to respective contact areas of an electronic component, each arm having integrally formed therewith a terminal member for connection to an external conductor, characterised in that each terminal member (4, 5, 6) is formed of a plurality of thicknesses of the sheet metal by folding part of the sheet metal constituting the terminal member and is shaped to mate with a complementary terminal terminating an insulated conductor.

2. A lead frame as claimed in Claim 1, characterised in that each terminal member (4, 5, 6) is in the form of a tab.

3. A lead frame as claimed in Claim 1 or Claim 2, integrally formed with a plurality of similar lead frames on a common carrier strip arrangement, characterised in that the carrier strip arrangement (7) comprises a pair of spaced, parallel side carrier strips (8, 9) joined by cross carrier strips (10, 11) each lead frame being positioned between an adjacent pair of cross carrier strips (10, 11), the outer ends of the terminal members (4, 5, 6) being integral with one side carrier strip (8) and a pair of adjacent cross carrier strips (10, 11) respectively, and the inner end of one terminal member (6) and the associated contact arm (3) being integral with the other side carrier strip (9).

4. A lead frame as claimed in Claim 1 or Claim 2, integrally formed with a plurality of similar lead frames on a common carrier strip arrangement, characterized in that the carrier strip arrangement (7) comprises a single strip (17) to which the inner ends of two of the terminal members (5, 6) and the outer end of the contact arm (1) associated with the other terminal member (4) are connected.

5. A lead frame as claimed in Claim 4, characterised in that said other terminal member (4) and the contact arm (1) associated therewith extend normally of the carrier strip (17) while said two terminal members (5, 6) extend parallel to the carrier strip (17).

6. A package comprising a lead frame having an electronic component (100) mounted thereon with contact arms (1, 2, 3) of the lead frame connected to respective contact areas of the component (100), each contact arm (1, 2, 3) having integrally formed therewith a terminal member (4, 5, 6) for connection to an external conductor, the contact arms (1, 2, 3) and associated terminal members (4, 5, 6) being electrically isolated from each other, with the contact arms (1, 2, 3) and portions of the terminal members (4, 5, 6) embedded in an encapsulating material (24) with free end portions of the terminal members (4, 5, 6) extending outside the encapsulating material (24), characterised in that the lead frame is as claimed in Claim 1 or Claim 2; the contact arms (1, 2, 3) are bonded to a substrate (18) of electrically insulating material; and the encapsulating material (24) is surrounded by a housing (21) in the form of a frame.

7. A package as claimed in Claim 6, characterised by a heat sink member (20) bonded to the substrate (18).

8. A package as claimed in Claim 6 or Claim 7, characterised in that each terminal member (4, 5, 6) has a through hole (16) therein within the housing (21), which hole (16) receives encapsulating material (24).

9. A package as claimed in Claim 8, characterised in that portions of the terminal members (4, 5, 6) outward of the holes (16) therein pass through individual holes (22) in the housing (21).

10. A package as claimed in Claim 9, characterised in that the terminal members (4, 5, 6) extent at right angles to the substrate (18).

**Patentansprüche**

1. Gestanzter und aus Metallblech gebildeter Leiterrahmen mit einer Mehrzahl von Kontaktarmen, die zur Verbindung mit entsprechenden Kontaktflächen eines elektronischen Bauteils ausgelegt sind, wobei jeder Arm ein einstückig mit diesem ausgebildetes Anschlußelement zur Verbindung mit einem äußeren Leiter aufweist, dadurch gekennzeichnet, daß jedes Anschlußelement (4, 5, 6) aus mehreren Dicken des Metallblechs durch Falten eines Teils des die Anschlußelemente bildenden Metallblechs gebildet ist und derart geformt ist, daß es mit einem einen isolierten Leiter abschließenden, komplementären Anschluß verbindbar ist.

2. Leiterrahmen nach Anspruch 1, dadurch gekennzeichnet, daß jedes Anschlußelement (4, 5, 6) die Form eines Flachsteckanschlusses aufweist.

3. Leiterrahmen nach Anspruch 1 oder Anspruch 2, wobei dieser mit einer Mehrzahl ähnlicher Leiterrahmen auf einer gemeinsamen Trägerstreifenanordnung einstückig ausgebildet ist, dadurch gekennzeichnet, daß die Trägerstreifenanordnung (7) ein Paar beabstandete, parallele Seitenträgerstreifen (8, 9) aufweist, die durch Querträgerstreifen (10, 11) miteinander verbunden sind, wobei jeder Leiterrahmen zwischen einem angrenzenden Paar von Querträgerstreifen (10, 11) positioniert ist, die äußeren Enden der Anschlußelemente (4, 5, 6) mit einem Seitenträgerstreifen (8) bzw. einem Paar angrenzender Querträgerstreifen (10, 11) einstückig ausgebildet sind, und das innere Ende des einen Anschlußelements (6) und der zugehörige Kontaktarm (3) mit dem anderen Seitenträgerstreifen (9) einstückig ausgebildet sind.

4. Leiterrahmen nach Anspruch 1 oder Anspruch 2, wobei dieser mit einer Mehrzahl ähnlicher Lieterrahmen auf einer gemeinsamen Trägerstreifenanordnung einstückig ausgebildet ist, dadurch gekennzeichnet, daß die Trägerstreifenanordnung (7) einen einzigen Streifen (17) aufweist, mit dem die inneren Enden zweier der Anschlußelemente (5, 6) und das äußere Ende des dem anderen Anschlußelement (4) zugeordneten Kontaktarms (1) verbunden sind.

5. Leiterrahmen nach Anspruch 4, dadurch gekennzeichnet, daß sich das andere Anschlußelement (4) und der diesem zugeordnete Kontaktarm (1) im rechten Winkel zum Trägerstreifen (17) erstrecken, während sich die zwei Anschlußelemente (5, 6) parallel zum Trägerstreifen (17) erstrecken.

6. Einheit enthaltend einen Leiterrahmen mit einem darauf befestigten elektronischen Bauteil (100), wobei Kontaktarme (1, 2, 3) des Leiterrahmens mit entsprechenden Kontaktflächen des Bauteils (100) verbunden sind, jeder Kontaktarm (1, 2, 3) ein einstückig mit diesem ausgebildetes Anschlußelement (4, 5, 6) zur Verbindung mit einem äußeren Leiter aufweist, die Kontaktarme (1, 2, 3) und die zugehörigen Anschlußelemente (4, 5, 6) elektrisch voneinander isoliert sind, und die Kontaktarme (1, 2, 3) und Teile der Anschlußelemente (4, 5, 6) in einem Vergußmaterial (24) eingebettet sind, wobei sich freie Endbereiche der Anschlußelemente (4, 5, 6) außerhalb des Vergußmaterials (24) erstrecken, dadurch gekennzeichnet, daß der Leiterrahmen wie in Anspruch 1 oder Anspruch 2 beansprucht ausgebildet ist, daß die Kontaktarme (1, 2, 3) mit einem Substrat (18) aus elektrisch isolierendem Material verbunden sind, und daß das Vergußmaterial (24) von einem Gehäuse (21) in Form eines Rahmens umgeben ist.

7. Einheit nach Anspruch 6, gekennzeichnet durch ein mit dem Substrat (18) verbundenes Kühlkörperelement (20).

8. Einheit nach Anspruch 6 oder Anspruch 7, dadurch gekennzeichnet, daß jedes Anschlußelement (4, 5, 6) ein in diesem ausgebildetes, durchgehendes Loch (16) innerhalb des Gehäuses (21) aufweist, wobei das Loch (18) Vergußmaterial (24) aufnimmt.

9. Einheit nach Anspruch 8, dadurch gekennzeichnet, daß sich Teile der Anschlußelemente (4, 5, 6), die sich außerhalb von den darin befindlichen Löchern (16) befinden, durch einzelne Löcher (22) in dem Gehäuse (21) erstrecken.

10. Einheit nach Anspruch 9, dadurch gekennzeichnet, daß sich die Anschlußelemente (4, 5, 6) in rechten Winkeln zum Substrat (18) erstrecken.

## Revendications

1. Grille de conducteurs emboutie er formée en tôle et comprenant plusieurs bras de contact disposés pour être connectés à des zones respectives de contact d'un composant électronique, chaque bras étant réalisé d'une seule pièce avec un élément de borne devant être connecté à un conducteur extérieur, caractérisée en ce que chaque élément de borne (4, 5, 6) est formé de plusieurs épaisseurs par pliage d'une partie de la tôle constituant les éléments de bornes et est façonné pour être accouplé avec une borne complémentaire terminant un conducteur isolé.

2. Grille de conducteurs selon la revendication 1, caractérisée en ce que chaque élément de borne (4, 5, 6) est sous la forme d'une languette.

3. Grille de conducteurs selon la revendication 1 ou la revendication 2, réalisée d'une seule pièce avec plusieurs grilles de conducteurs analogues sur un ensemble commun à bandes de support, caractérisée en ce que l'ensemble (7) à bandes de support comprend deux bandes latérales parallèles et espacées (8, 9) de support reliées par des bandes transversales (10, 11) de support, chaque grille de conducteurs étant positionnée entre deux bandes transversales adjacentes (10, 11) de support, les extrémités extérieures des éléments de bornes (4, 5, 6) faisant partie intégrante d'une bande latérale (8) de support et de deux bandes transversales adjacentes (10, 11) de support, respectivement, et l'extrémité intérieure d'un élément de borne (6) et du bras associé (3) de contact faisant partie intégrante de l'autre bande latérale (9) de support.

4. Grille de conducteurs selon la revendication 1 ou la revendication 2, réalisée d'une seule pièce avec plusieurs grilles de conducteurs analogues sur un ensemble commun à bande de support, caractérisée en ce que l'ensemble (7) à bande de support comprend une seule bande (17) à laquelle les extrémités intérieures de deux des éléments de bornes (5, 6) et l'extrémité extérieure du bras (1) de contact associé à l'autre élément de borne (4) sont reliées.

5. Grille de conducteurs selon la revendication 4, caractérisée en ce que ledit autre élément de borne (4) et le bras (1) de contact qui lui est associé s'étendent normalement à la bande (17) de support, tandis que lesdits deux éléments de bornes (5, 6) s'étendent parallèlement à la bande (17) de support.

6. Boîtier comprenant une grille de conducteurs sur laquelle un composant électronique (100) est monté, des bras de contact (1, 2, 3) de la grille de conducteurs étant connectés à des zones respectives de contact du composant (100), chaque bras de contact (1, 2, 3) étant réalisé d'une seule pièce avec un élément de borne (4, 5, 6) devant être connecté à un conducteur extérieur, les bras de contact (1, 2, 3) et les éléments de bornes associés (4, 5, 6) étant isolés électriquement les uns des autres, les bras de contact (1, 2, 3) et des parties des éléments de bornes (4, 5, 6) étant noyés dans une matière d'enrobage (24) de manière que des tronçons extrêmes libres des éléments de bornes (4, 5, 6) fassent saillie vers l'extérieur de la matière d'enrobage (24), caractérisé en ce que la grille de conducteurs est telle que revendiquée dans la revendication 1 ou la revendication 2; les bras de contact (1, 2, 3) sont fixés à un substrat (18) en matière électriquement isolante; et la matière d'enrobage (24) est entourée par un corps (21) ayant la forme d'un cadre.

7. Boîtier selon la revendication 6, caractérisé par un élément radiateur de chaleur (20) fixé au substrat (18).

8. Boîtier selon la revendication 6 ou la revendication 7, caractérisé en ce que chaque élément de borne (4, 5, 6) est traversé d'un trou (16) à l'intérieur du corps (21), lequel trou (16) reçoit de la matière d'enrobage (24).

9. Boîtier selon la revendication 8, caractérise en ce que des parties des éléments de bornes (4, 5, 6) extérieures aux trous (16) de ces éléments pénètrent dans des trous séparés (22) ménagés dans le corps (21).

10. Boîtier selon la revendication 9, caractérisé en ce que les éléments de bornes (4, 5, 6) s'étendent perpendiculairement au substrat (18).

FIG.1.

FIG.2.

FIG.3.

FIG.4.

FIG.5.

FIG.6.